# EUROPEAN PATENT APPLICATION

(11) **EP 2 346 067 A2**
(43) Date of publication of application: **20.07.2011**
(21) Application number: 11150542.6
(22) Date of filing: 11.01.2011
(51) Int. Cl.: H01L 21/02, H01L 23/522, H01L 27/06, H02M 3/07

(54) **Capacitance under a fringe capacitor of a radio frequency integrated circuit**

(30) Priority: 12.01.2010 US 686318
(71) Applicant: NXP B.V., 5656 AG Eindhoven (NL)
(72) Inventor: Bergler, Ewald, 5656 AE, Eindhoven (NL); Brandl, Roland, 5656 AE, Eindhoven (NL); Spindler, Robert, 5656 AE, Eindhoven (NL); Entner, Robert, 5656 AE, Eindhoven (NL)
(74) Representative: Krott, Michel

(57) **Abstract**

A capacitance system for a radio frequency (RF) charge pump of an RF integrated circuit (IC) includes a fringe capacitor (302), a second capacitor (304), and a silicon substrate region (306). The fringe capacitor is made of backend masks (M1,M2). The second capacitor is located underneath the fringe capacitor. The silicon substrate region is located underneath the second capacitor.

## Description

Embodiments of the invention relate generally to capacitance systems and, more particularly, to a capacitance system of a radio frequency (RF) integrated circuit (IC).

An RF IC communicates with other RF communications devices via electromagnetic waves in the radio frequency range. In order to reach a predefined communications range for the RF IC, an RF charge pump may be used as the interface between an antenna of the RF IC and the rest of the RF IC. However, real losses on alternating current (AC) nodes of the RF charge pump can destroy the efficiency of the RF charge pump. To achieve a high efficiency for the RF charge pump, the losses on the AC nodes of the RF charge pump have to be kept as low as possible. By making the resistive part of the parasitic capacitance of the RF charge pump either zero or infinity, the real losses on the AC nodes of the RF charge pump can be eliminated. However, to make the resistive part of the parasitic capacitance either zero or infinity, various limitations may be put on the characteristics of the substrate of the RF charge pump, which in turn increase the cost of implementing the substrate. Therefore, there is a need to provide a capacitance system for an RF charge pump such that the losses on the AC nodes of the RF charge pump can be reduced without putting costly limitations on the substrate.

A capacitance system for an RF charge pump of an RF IC includes a fringe capacitor, a second capacitor, and a silicon substrate region. The fringe capacitor is made of backend masks. The second capacitor is located underneath the fringe capacitor. The silicon substrate region is located underneath the second capacitor.

In an embodiment, a capacitance system for an RF charge pump of an RF IC includes a fringe capacitor, a second capacitor, and a silicon substrate region. The fringe capacitor is made of backend masks, the second capacitor is located underneath the fringe capacitor, and the silicon substrate region is located underneath the second capacitor.

In an embodiment, an RF charge pump for an RF IC includes a capacitance system. The capacitance system includes a fringe capacitor, a second capacitor, and a silicon substrate region. The fringe capacitor includes stacked finger-shaped metal layers, where the stacked finger-shaped metal layers are connected through metal vias. The second capacitor is located underneath the fringe capacitor. The silicon substrate region is located underneath the second capacitor.

In an embodiment, an RF IC includes an antenna, IC circuitry, and an RF charge pump. The RF charge pump includes a capacitance system. The capacitance system includes a fringe capacitor, a second capacitor, and a silicon substrate region. The fringe capacitor includes stacked finger-shaped metal layers, where the stacked finger-shaped metal layers are connected through metal vias. The second capacitor is located underneath the fringe capacitor. The silicon substrate region is located underneath the second capacitor.

Other aspects and advantages of embodiments of the present invention will become apparent from the following detailed description, taken in conjunction with the accompanying drawings, depicted by way of example of the principles of the invention.
Fig. 1 is a schematic block diagram of an RF IC in accordance with an embodiment of the invention.
Fig. 2 is a circuit diagram of an exemplary p-channel MOSFET.
Fig. 3 depicts a perspective view of an exemplary capacitance system.
Fig. 4 depicts a top view of a fringe capacitor of the capacitance system of Fig. 3.
Fig. 5 depicts an exemplary supply-voltage-decoupling capacitor of the capacitance system of Fig. 3.
Fig. 6 illustrates a sectional view of the capacitance system of Fig. 3.
Fig. 7 depicts a perspective view of another exemplary capacitance system.
Fig. 8 illustrates a sectional view of the capacitance system of Fig. 7.

Throughout the description, similar reference numbers may be used to identify similar elements.

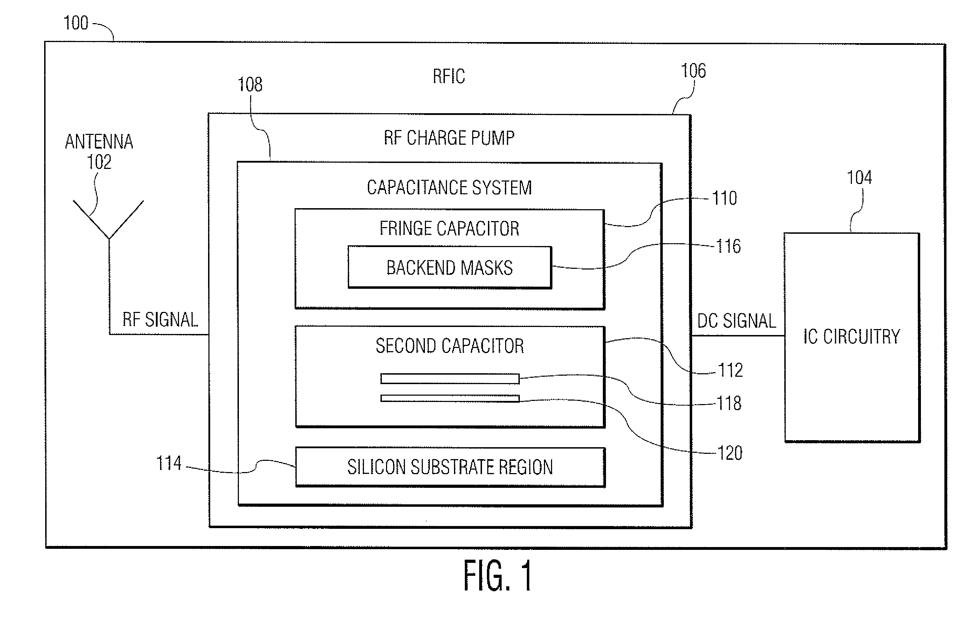

Fig. 1 is a schematic block diagram of an RF IC 100 in accordance with an embodiment of the invention. As shown in Fig. 1, the RF IC includes an antenna 102, IC circuitry 104, and an RF charge pump 106 that serves as an RF-DC (Direct current) converter. The antenna may be a loop antenna or a dipole antenna. The IC circuitry is configured to process an incoming DC signal from the charge pump to extract communications data. Additionally, the IC circuitry is configured to produce and to send an outgoing DC signal that carries communications data to the RF charge pump. The RF charge pump is configured to convert an RF signal that is received from the antenna into a DC signal for the IC circuitry and to convert a DC signal that is received from the IC circuitry into an RF signal for the antenna. The RF charge pump may include multiple RF/DC conversion stages (not shown). In an embodiment, the RF IC is an RF identification (ID) system such as an ultra high frequency (UHF) RF ID tag, which communicates in frequency ranges between 300 MHz and 3 GHz and has read and write ranges of several meters. In order to reach the read and write ranges of several meters, the RF charge pump is used as the interface between the antenna and the IC circuitry.

In the embodiment of Fig. 1, the RF charge pump 106 include a capacitance system 108 that has a fringe capacitor 110, a second capacitor 112 located underneath the fringe capacitor, and a silicon substrate region 114 located underneath the second capacitor. The fringe capacitor includes backend masks 116 to achieve a high quality factor and low parasitic characteristic. The backend masks may include multiple metal layers that are used for wiring. For example, the backend masks include one to six metal layers. The fringe capacitor may be a metal fringe capacitor, a MIM (metal-isolator-metal) capacitor, or a metal-cap capacitor. For example, the fringe capacitor includes stacked finger-shaped metal layers that are connected through metal vias. Compared to plate backend capacitors, the fringe capacitor can produce a larger capacitance per unit area. A parasitic capacitor (not shown) exists between the fringe capacitor and the second capacitor 112.

In the embodiment of Fig. 1, the second capacitor 112 includes at least two conducting plates 118, 120, with at least one of the at least two conducting plates being a low ohmic conducting plate 118. The sheet resistance of the material of the low ohmic conducting plate is lower than the sheet resistance of the material of any other substrate component. For example, the low ohmic conducting plate may be made of polycrystalline silicon (poly silicon), which has a low sheet resistance of, for example, 8 Ohms per square. In an embodiment, the low ohmic conducting plate is connected to the ground (GND) while the other conducting plate is connected to the supply voltage of the RF IC 100. In an embodiment, the distance between the low ohmic conducting plate and the fringe capacitor is less than the distance between any other conducting plate of the two conducting plates and the fringe capacitor. The second capacitor 112 may include an isolator (not shown) that fills the space between the two conducting plates. The isolator may be made of gate oxide, which is one of the thinnest oxides that can be used for manufacturing capacitances. Alternatively, the isolator can be implemented in other materials. However, the capacitance increases with increasing plate area and decreasing plate distance. As a result, compared with other isolation materials, using gate oxide as the isolator can produce a higher capacitance for the second capacitor.

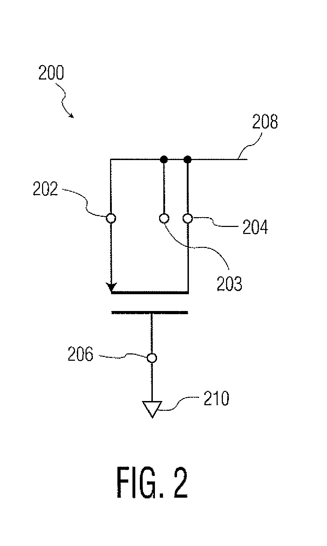

The second capacitor 112 may include a p-channel metal-oxide-semiconductor field effect transistor (MOSFET), which is also referred to as a P type MOSFET. A circuit diagram of an exemplary p-channel MOSFET 200 is depicted in Fig. 2. As shown in Fig. 2, the p-channel MOSFET has a source terminal 202, a bulk terminal 203, a drain terminal 204, and a gate terminal 206. The source terminal, the bulk terminal, and the drain terminal are connected together and are tied to a supply voltage 208 of the RF IC 100 while the gate terminal is connected to the ground (GND) 210. To reduce the supply voltage ripple, the supply voltage of the RF IC has to be decoupled with capacitances. By forming the p-channel MOSFET underneath the fringe capacitor 110 as a decoupling capacitance for the supply voltage of the RF IC, the fringe capacitor provides the capacitance for the RF charge pump while the second capacitor provides the decoupling capacitance for the supply voltage of the RF IC. Because the fringe capacitor and the second capacitor are located above the same silicon substrate region 114, a single piece of silicon substrate serves as the substrate for both the fringe capacitor and the second capacitor. As a result, the expensive silicon substrate area can be saved.

In an embodiment, the p-channel MOSFET 200 includes a source region, a bulk region, a drain region, and a gate region. The low ohmic conducting plate 118 includes the gate region and the other conducting plate 120 includes the source region, the bulk region, and the drain region. The source region, the bulk region, and the drain region may be formed on the silicon substrate region 114. In an embodiment, the source terminal 202 is connected to the source region, the bulk terminal 203 is connected to the bulk region, the drain terminal 204 is connected to the drain region, and the gate terminal 206 is connected to the gate region.

In an embodiment, the second capacitor 112 is located underneath the fringe capacitor 110 such that there is a maximum parasitic capacitance to the gate terminal 206 of the p-channel MOSFET 200 and a minimum parasitic capacitance to the silicon substrate region 114. To realize the maximum parasitic capacitance to the gate terminal and the minimum parasitic capacitance to the silicon substrate region, the center of gravity of the fringe capacitor matches the center of gravity of the second capacitor. Because the fringe capacitor and the second capacitor have the same center of gravity, the overlap between the fringe capacitor and the second capacitor is maximized.

In an embodiment, the second capacitor 112 does not include a p-channel MOSFET 200. For example, the second capacitor includes the low ohmic conducting plate 118 and the conducting plate 120, while the conducting plate 120 includes at least one n-well that is formed on the substrate region 114. The conducting plate 120 may include two n-wells that are formed on the substrate region and the two n-wells are connected to the supply voltage 208 of the RF IC 100.

Turning back to Fig. 1, the silicon substrate region 114, which is an epitaxial-type substrate region, is located underneath the second capacitor 112 and the second capacitor is located underneath the fringe capacitor 110. Because of the distance between the fringe capacitor and the silicon substrate region, there is parasitic capacitance toward the substrate region. By making the resistive part of the parasitic capacitance either zero or infinity, the real losses on the AC nodes of the RF charge pump can be eliminated. Without the second capacitor, to make the resistive part of the parasitic capacitance either zero or infinity, a very low ohmic substrate region or a very high ohmic substrate region is required for the RF charge pump. However, the characteristics of the substrate are usually chosen based on other criteria such as the cost, electrostatic discharge (ESD), and latchup. Additionally, without the second capacitor, the substrate region typically will have to be connected such that the zero or infinity resistance of the resistive part of the parasitic capacitance can be achieved and sustained.

By forming the second capacitor 112 underneath the fringe capacitor 110 and above the silicon substrate region 114, the silicon substrate region can fulfill the requirement of a low ohmic substrate connection without having to be connected. As a result, it is easier and less costly to manufacture the silicon substrate region.

Because the fringe capacitor and the second capacitor are located above the same silicon substrate region, the footprint of the RF charge pump is smaller than the footprint of the RF charge pump would be if the fringe capacitor and the second capacitor were located on different silicon substrate regions. Additionally, by forming the second capacitor underneath the fringe capacitor and above the silicon substrate region, real losses on AC nodes of the RF charge pump 106 are reduced or even eliminated. Because the real losses on the AC nodes of the RF charge pump are reduced or even eliminated, the efficiency of the RF charge pump is improved.

Instead of the second capacitor 112, a low ohmic layer such as a poly silicon layer can be placed underneath the fringe capacitor 110 and above the silicon substrate region 114 and can be connected to the ground (GND). Compared with the second capacitor, the low ohmic layer can achieve a better connection between the parasitic capacitances and the substrate. However, by placing the second capacitor underneath the fringe capacitor and above the silicon substrate region, a single piece of silicon substrate serves as the substrate for both the fringe capacitor and the second capacitor.

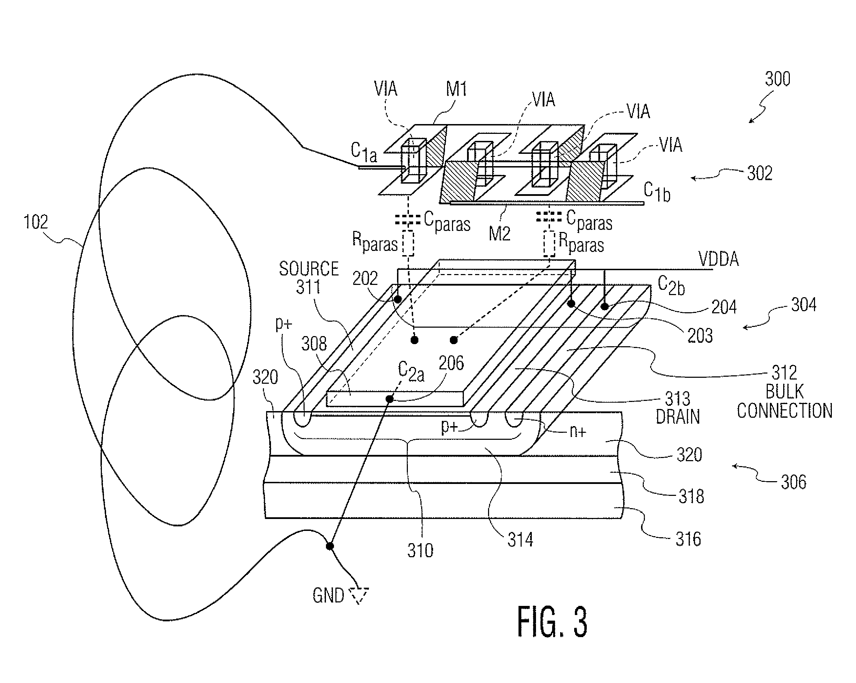

Two exemplary embodiments of the capacitance system 108 of Fig. 1 are described below with reference to Figs. 3-8. Fig. 3 illustrates a prospective view of an embodiment of the capacitance system 108 of Fig. 1. As shown in Fig. 3, the capacitance system 300 includes a fringe capacitor 302, a supply-voltage-decoupling capacitor 304, and a silicon substrate region 306.

In the embodiment of Fig. 3, the fringe capacitor 302 includes stacked finger-shaped metal layers that are connected through metal vias. The fringe capacitor also takes advantage of the edge capacitances between the metal fingers and the metal vias. As shown in of Fig. 3, the fringe capacitor includes two metal layers labeled "M1" and "M2" and metal vias labeled "VIA" that connect the two metal layers M1 and M2. In some embodiments, the two metal layers M1 and M2 are exchangeable. In the embodiment of Fig. 3, the metal layer M1 is on the top of the fringe capacitor and the metal layer M2 is on the bottom of the fringe capacitor with the metal vias VIA connecting the metal layers M1 and M2. The top metal layer M1 is also connected to the bottom metal layer M2 without the metal vias. Besides the metal layers and the metal vias, the fringe capacitor also includes two connectors "C₁ₐ" and "C_{1b}." As shown in Fig. 1, the connector C₁ₐ of the fringe capacitor is connected to the antenna 102. The connector C_{1b} of the fringe capacitor is connected to the IC circuitry 104 (shown in Fig. 1) of the RF IC 100.

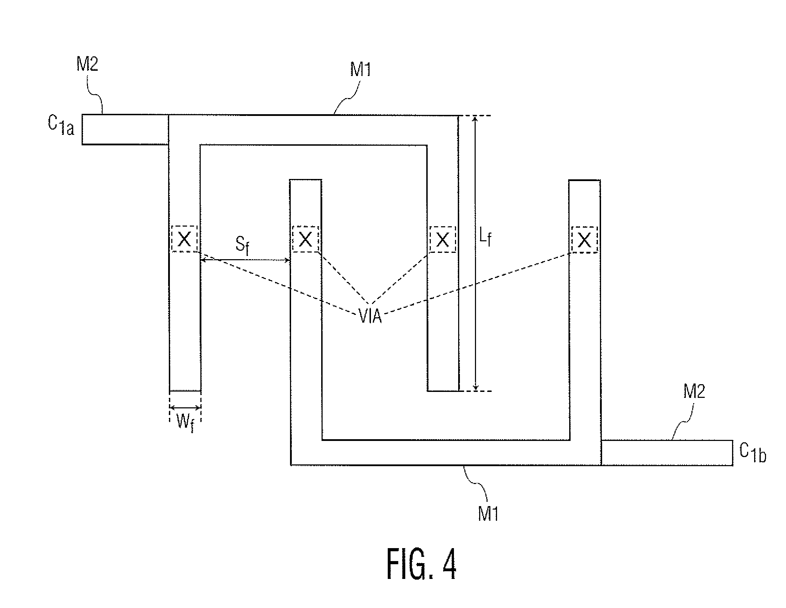

A top view of the fringe capacitor 302 of Fig. 3 is depicted in Fig. 4. In the embodiment of Fig. 4, the top metal layer M1 covers most of the bottom metal layer M2 and the metal vias VIA are completely covered by the top metal layer M1. The bottom metal layer M2 is connected to the two connectors C₁ₐ, and C_{1b} of the fringe capacitor. Each of the metal layers M1 and M2 includes metal fingers, where each metal finger has a finger width "Wf" and a finger length "Lf" The distance between two metal fingers is referred to as the finger spacing "Sf." The finger width Wf may be 0.296 micrometers (*µ*m) while the finger spacing Sfmay be 0.28 *µ*m.

Turning back to Fig. 3, the supply-voltage-decoupling capacitor 304 is located underneath the fringe capacitor 302. The supply-voltage-decoupling capacitor provides decoupling capacitance for the supply voltage of the RF IC 100. As shown in Fig. 3, two parasitic capacitances, Cₚₐᵣₐₛ, and two parasitic resistances to the substrate, Rₚₐᵣₐₛ, are located between the supply-voltage-decoupling capacitor and the fringe capacitor 302. In some embodiments, the supply-voltage-decoupling capacitor is located in a position underneath the fringe capacitor such that the parasitic resistance to the negative antenna connection is reduced to a minimum level.

As shown in Fig. 3, the supply-voltage-decoupling capacitor includes two connectors "C₂ₐ" and "C_{2b}" and two conducting plates 308, 310. One of the conducting plates 308, also referred to as the low ohmic conducting plate, is formed by poly silicon that has a low sheet resistance, for example, 8 Ohms per square. The low ohmic conducting plate 308 is connected to the ground (GND) through the connector "C₂ₐ." The other conducting plate 310 of the supply-voltage-decoupling capacitor is connected to the supply voltage (VDDA) of the RF IC 100 through another connector "C_{2b}." The conducting plate 310 is formed by an n-well region 314 on the silicon substrate region 306. The n-well region has a typical sheet resistance of 1500 Ohms per square.

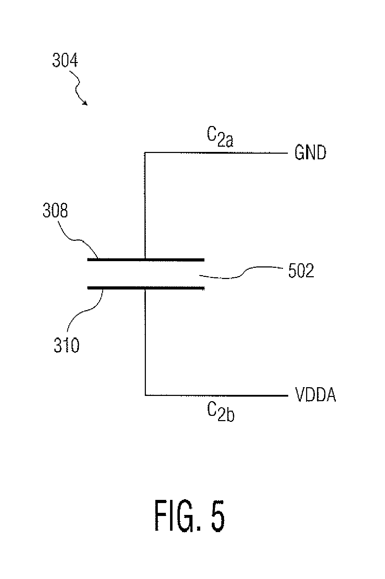

A functional depiction of the supply-voltage-decoupling capacitor 304 of Fig. 3 is shown in Fig. 5. As shown in Fig. 5, the low ohmic conducting plate 308 of the supply-voltage-decoupling capacitor is connected to the ground (GND) through the connector "C_{2b}." The other conducting plate 310 of the supply-voltage-decoupling capacitor is connected to the supply voltage of the RF IC 100 through another connector "C₂ₐ." An isolator 502 fills the space between the two conducting plates and is made of gate oxide. Alternatively, the isolator can be implemented in other materials. However, the capacitance increases with increasing plate area and decreasing plate distance. As a result, compared with other isolation materials, using gate oxide as the isolator can produce a higher capacitance for the supply-voltage-decoupling capacitor.

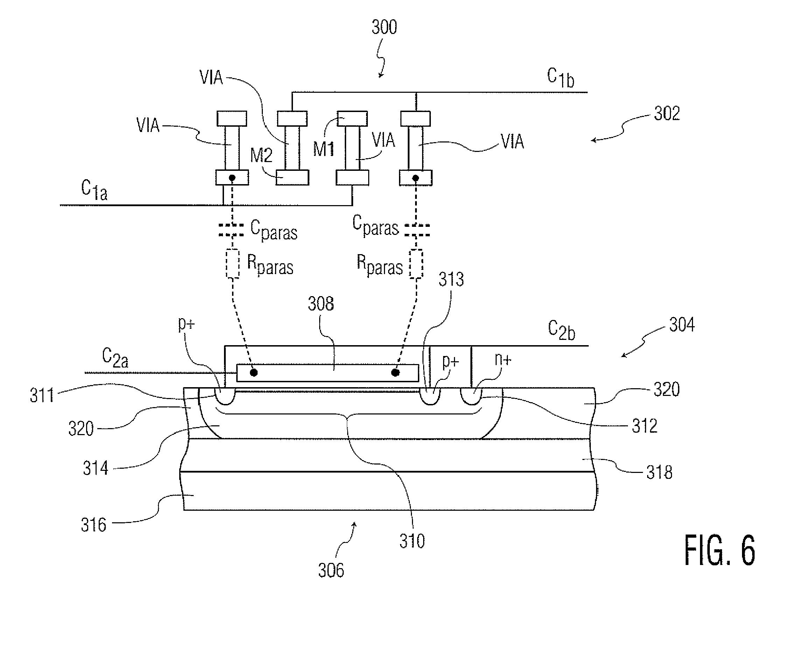

A sectional view of the capacitance system 300 of Fig. 3 is illustrated in Fig. 6. In the embodiment depicted in Fig. 3 and Fig. 6, the supply-voltage-decoupling capacitor 304 is a p-channel MOSFET that is the same or similar to the p-channel MOSFET 200 of the embodiment of Fig. 2. The p-channel MOSFET includes a source terminal 202, a bulk terminal 203, a drain terminal 204, a gate terminal 206, a source region 311, a bulk region or a bulk connection region 312, a drain region 313, and a gate region that is the low ohmic conducting plate 308. The source region, the bulk region, and the drain region are formed on the silicon substrate region 306. The other conducting plate 310 of the two conducting plates 308, 310 includes the source region, the bulk region, and the drain region. The source terminal is connected to the source region, the bulk terminal is connected to the bulk region, the drain terminal is connected to the drain region, and the gate terminal is connected to the gate region. In the embodiment of Fig. 3, the source terminal, the bulk terminal, and the drain terminal are connected together and are tied to the supply voltage (VDDA) of the RF IC 100 through the connector "C₂ₐ," while the gate terminal is the connector "C_{2b}," which is connected to the ground (GND).

In the embodiment of Fig. 3, the silicon substrate region 306 may be an epitaxial-type substrate region. As shown in Fig. 3, the silicon substrate region includes the n-well region 314, a bulk material region 316, an epitaxial "epi" layer 318, and p-well regions 320. The n-well region has a typical sheet resistance of 1500 Ohms per square. The bulk material region may contain p-type Cochralsky (CZ) silicon with a typical resistivity of 0.01Ωcm. The epi layer, which is formed on top of the bulk material region, is lightly p-type doped, is about 4µm thick, and has a resistivity of around 10 Ωcm. The n-well region and p-well regions may be formed on the top surface of the epi layer such that every point on the silicon surface is covered by either an n-well region or a p-well region.

By placing the supply-voltage-decoupling capacitor 304, which includes a p-channel MOSFET, under the fringe capacitor 302 as a decoupling capacitance for the RF IC 100, a better antenna ground connection of the parasitic can be realized. In other words, by connecting the supply-voltage-decoupling capacitor as a decoupling capacitance, the parasitic resistance to the substrate Rₚₐᵣₐₛ of the parasitic capacitance Cₚₐᵣₐₛ can be reduced. Without the supply-voltage-decoupling capacitor 304, the parasitic resistance is close to the typical sheet resistance of the n-well region 314, which is 1,500 Ohms per square, or the typical sheet resistance of the p-well region 320, which is 4,340 Ohms per square. With the supply-voltage-decoupling capacitor, the parasitic resistor in Fig. 3 is equal to the typical sheet resistance of the poly silicon 312, which is 8 Ohms per square. Additionally, because the supply-voltage-decoupling capacitor can serve as a buffer capacitor, the substrate serves dual purposes.

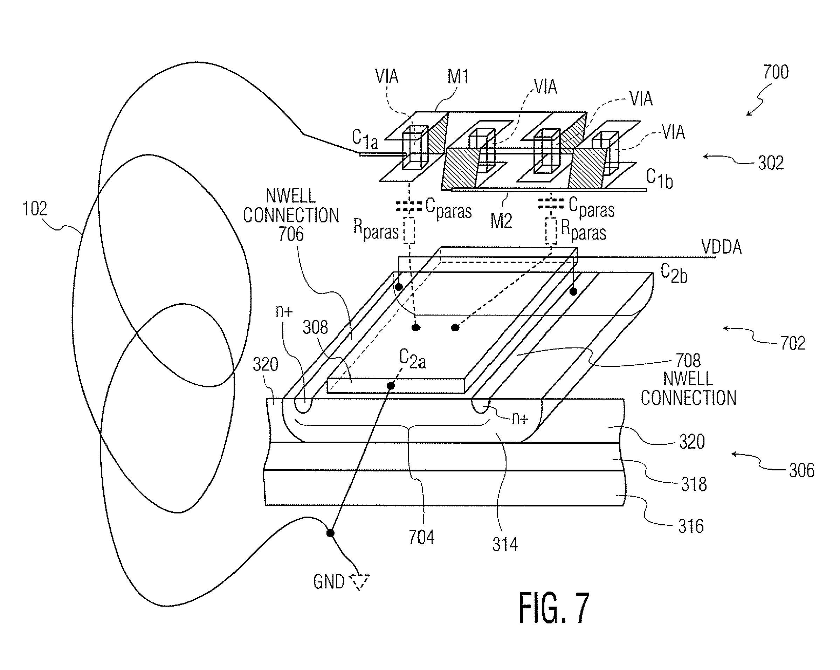

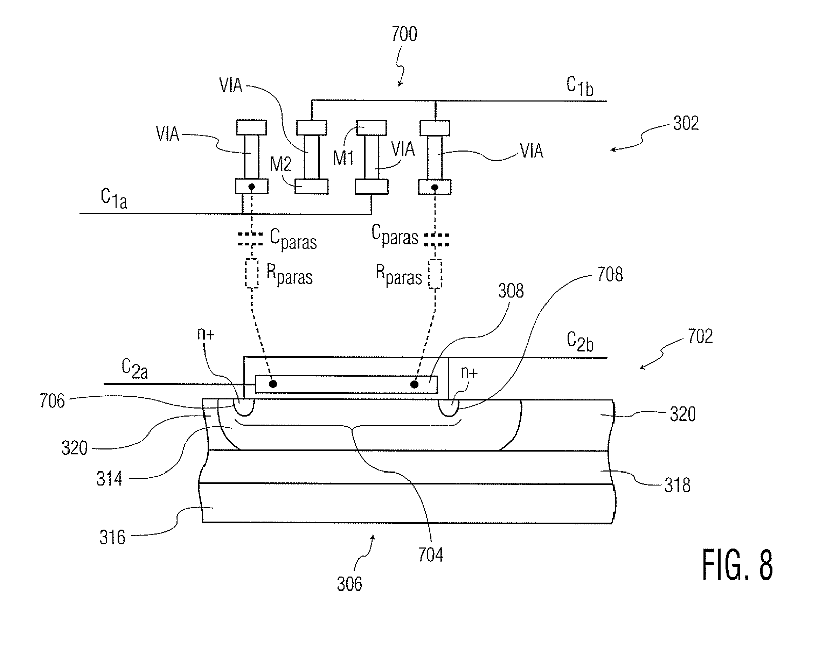

Fig. 7 illustrates a prospective view of another embodiment of the capacitance system 108 of Fig. 1. As shown in Fig. 7, the capacitance system 700 includes a fringe capacitor 302, a supply-voltage-decoupling capacitor 702, and a silicon substrate region 306. A sectional view of the capacitance system 700 of Fig. 7 is illustrated in Fig. 8. The capacitance system 700 depicted in Figs. 7 and 8 is similar to the capacitance system 300 depicted in Figs. 3-6 except that the supply-voltage-decoupling capacitor 702 in Figs. 7 and 8 does not form a p-channel MOSFET as does the supply-voltage-decoupling capacitor 304 in the embodiment depicted in Figs. 3-6. Instead, the supply-voltage-decoupling capacitor 702 in Figs. 7 and 8 includes a low ohmic conducting plate 308 and another conducting plate 704 that includes two n-wells or n-well connection regions 706, 708. The n-wells 706, 708 are formed on the substrate region 306 and are connected to the supply voltage (VDDA) of the RF IC 100.

Although specific embodiments of the invention that have been described or depicted include several components described or depicted herein, other embodiments of the invention may include fewer or more components to implement less or more functionality.

In addition, although specific embodiments of the invention have been described and depicted, the invention is not to be limited to the specific forms or arrangements of parts so described and depicted. The scope of the invention is to be defined by the claims appended hereto and their equivalents.

## Claims

1. A capacitance system for a radio frequency (RF) charge pump of an RF integrated circuit (IC), the capacitance system comprising:
a fringe capacitor made of backend masks;
a second capacitor located underneath the fringe capacitor; and
a silicon substrate region located underneath the second capacitor.

2. The capacitance system of claim 1, wherein the fringe capacitor comprises stacked finger-shaped metal layers, and wherein the stacked finger-shaped metal layers are connected through metal vias.

3. The capacitance system of claim 1, wherein the second capacitor comprises two conducting plates, and wherein at least one of the two conducting plates is a low ohmic conducting plate.

4. The capacitance system of claim 3, wherein the other conducting plate of the two conducting plates includes an n-well that is formed on the substrate region.

5. The capacitance system of claim 3, wherein the low ohmic conducting plate is connected to the ground (GND), wherein the other conducting plate of the two conducting plates includes two n-wells that are formed on the substrate region, and wherein the two n-well regions are connected to a supply voltage of the RF IC.

6. The capacitance system of claim 3, wherein the low ohmic conducting plate is made of polycrystalline silicon (poly silicon).

7. The capacitance system of claim 3, wherein the second capacitor further comprises an isolator between the two conducting plates, and wherein the isolator is made of gate oxide.

8. The capacitance system of claim 1, wherein the center of gravity of the fringe capacitor matches the center of gravity of the second capacitor.

9. The capacitance system of claim 1, wherein the RF IC comprises an antenna, the RF charge pump, and IC circuitry.

10. A radio frequency (RF) charge pump for an RF integrated circuit (IC) comprising a capacitance system, wherein the capacitance system comprises:
a fringe capacitor comprising stacked finger-shaped metal layers, wherein the stacked finger-shaped metal layers are connected through metal vias;
a second capacitor located underneath the fringe capacitor; and
a silicon substrate region located underneath the second capacitor.

11. The RF charge pump of claim 10, wherein the second capacitor comprises two conducting plates, wherein one of the two conducting plates is a low ohmic conducting plate, wherein the second capacitor comprises a p-channel metal-oxide-semiconductor field effect transistor (MOSFET), wherein the p-channel MOSFET comprises a source terminal, a bulk terminal, a drain terminal, a gate terminal, a source region, a bulk region, a drain region, and a gate region, wherein the source terminal, the bulk terminal, and the drain terminal are connected together and are tied to a supply voltage of the RF IC, wherein the gate terminal is connected to the ground (GND), wherein the source region, the bulk region, and the drain region are formed on the silicon substrate region, wherein the source terminal is connected to the source region, the bulk terminal is connected to the bulk region, the drain terminal is connected to the drain region, and the gate terminal is connected to the gate region, wherein the low ohmic conducting plate includes the gate region, and wherein the other conducting plate of the two conducting plates includes the source region, the bulk region, and the drain region.

12. The RF charge pump of claim 10, wherein the second capacitor comprises two conducting plates, wherein one of the two conducting plates is a low ohmic conducting plate, wherein the other conducting plate of the two conducting plates includes an n-well that is formed on the substrate region, wherein the low ohmic conducting plate is connected to the ground (GND), and wherein the n-well region is connected to a supply voltage of the RF IC.

13. A radio frequency (RF) integrated circuit (IC), wherein the RF IC comprises:
an antenna;
IC circuitry; and
an RF charge pump comprising a capacitance system, wherein the capacitance system comprises:
a fringe capacitor comprising stacked finger-shaped metal layers,
wherein the stacked finger-shaped metal layers are connected through metal vias;
a second capacitor located underneath the fringe capacitor; and
a silicon substrate region located underneath the second capacitor.

14. The RF IC of claim 13, wherein the second capacitor comprises two conducting plates, wherein one of the two conducting plates is a low ohmic conducting plate, wherein the second capacitor comprises a p-channel metal-oxide-semiconductor field effect transistor (MOSFET), wherein the p-channel MOSFET comprises a source terminal, a bulk terminal, a drain terminal, a gate terminal, a source region, a bulk region, a drain region, and a gate region, wherein the source terminal, the bulk terminal, and the drain terminal are connected together and are tied to a supply voltage of the RF IC, wherein the gate terminal is connected to the ground (GND), wherein the source region, the bulk region, and the drain region are formed on the silicon substrate region, wherein the source terminal is connected to the source region, the bulk terminal is connected to the bulk region, the drain terminal is connected to the drain region, and the gate terminal is connected to the gate region, wherein the low ohmic conducting plate includes the gate region, and wherein the other conducting plate of the two conducting plates includes the source region, the bulk region, and the drain region.

15. The RF IC of claim 13, wherein the second capacitor comprises two conducting plates, wherein one of the two conducting plates is a low ohmic conducting plate, wherein the other conducting plate of the two conducting plates includes an n-well that is formed on the substrate region, wherein the low ohmic conducting plate is connected to the ground (GND), and wherein the n-well region is connected to a supply voltage of the RF IC.
